# EUROPEAN PATENT APPLICATION

(11) **EP 4 641 229 A1**
(43) Date of publication of application: **29.10.2025**
(21) Application number: 24172442.6
(22) Date of filing: 25.04.2024
(51) Int. Cl.: G01R 31/36, G01N 3/30, G01N 33/00, H01M 10/42, G01N 7/08, G01M 7/08, G01M 99/00

(54) **A GAS TREATMENT ARRANGEMENT AND TRANSPORTABLE TEST ARRANGEMENT**

(71) Applicant: Proventia Oy, 90460 Oulunsalo (FI)
(72) Inventor: Vuokila, Panu, 90460 Oulunsalo (FI); Koskela, Ilkka, 90460 Oulunsalo (FI); Kervinen, Harri, 90460 Oulunsalo (FI); Ruotsalainen, Mikko, 90460 Oulunsalo (FI); Mäkikangas, Ville, 90460 Oulunsalo (FI); Posio, Hanna, 90460 Oulunsalo (FI)
(74) Representative: Kolster Oy Ab

(57) **Abstract**

A gas treatment arrangement (100) for a transportable test chamber (800) of an electric component (510) comprising: a channel portion (102) configured to be connectable with the test chamber (800) and comprises a gas cleaning apparatus (300); wherein the gas cleaning apparatus comprises an oxidation catalyst (304) and a particulate filter (306). The gas cleaning apparatus (300) further comprising a temperature control arrangement (302) arranged upstream of the oxidation catalyst (304) and the particulate filter (306), wherein the temperature control arrangement is configured to control temperature of a first gas stream from the test chamber (800).

## Description

### Field

The invention relates to a gas treatment arrangement for a test chamber of an electric component. Specifically, the electric component may be a battery of an electric vehicle. The invention also relates to a transportable test arrangement comprising the gas treatment arrangement.

### Background

Manufacturers of electric car components such as engine or battery manufacturers, and/or car manufacturers, require testing facilities for testing the electric car components where to test components at varying environmental conditions and extreme circumstances to gain more information on robustness and safety measures of the components. As electric vehicles become more and more popular, it is increasingly important to inspect the capabilities of electric components, such as batteries.

In tests, batteries may be exposed to potentially damaging conditions, such as high or low temperatures, mechanical forces, and/or mechanical damage to break and/or test the battery structures. However, testing of an electric component, such as car battery, may then produce gases that may comprise harmful (e.g., toxic) and/or burnable compounds such as carbon dioxide, carbon monoxides, electrolyte vapor and/or hydrocarbons. Those harmful and/or burnable compounds should be treated before their introduction into the environment. There is a need to develop exhaust gas treatment of electric component tests so that exhaust gases would be less harmful for the environment as well as to ensure safe ventilation of gases in testing facilities.

### Brief description

The present invention seeks to provide a gas treatment arrangement and transportable test arrangement in which problems of prior art have been mitigated.

The invention is defined by the independent claims. Embodiments are defined in the dependent claims.

If one or more of the embodiments is considered not to fall under the scope of the independent claims, such an embodiment is or such embodiments are still useful for understanding features of the invention.

### List of drawings

Example embodiments of the present invention are described below, by way of example only, with reference to the accompanying drawings, in which
Figure 1 illustrates an example of a gas treatment arrangement according to an embodiment of the invention;
Figure 2 illustrates an example of a gas treatment apparatus according to an embodiment of the invention;
Figures 3-5 illustrate examples of a gas treatment apparatus and a transportable test arrangement according to embodiments of the invention; and
Figures 6-7 illustrate of examples of a gas treatment arrangement comprising a mixing unit according to embodiments of the invention.

### Description of embodiments

The following embodiments are only examples. Although the specification may refer to "an" embodiment in several locations, this does not necessarily mean that each such reference is to the same embodiment(s), or that the feature only applies to a single embodiment.

The articles "a" and "an" give a general sense of entities, structures, components, compositions, operations, functions, connections or the like in this document. Note also that singular terms may include pluralities.

Electric components may be tested in a dedicated test chamber. The test chamber may be arranged in a transportable container that is a standard-size freight container. In particular, container-based freight transport allows shippers to manage transport of standard sized containers, with little or no regard from what they might contain. The International Organization for Standardization (ISO) maintains standards of such general-purpose and specific-purpose containers. ISO containers, or containers complying with ISO-standards have fittings in corners of the container to enable lifting and handling the container.

Under the ISO standards, there are five common standard lengths, 20 ft, 40 ft, 45 ft, 48 ft, and 53 ft. Container capacity is often expressed in twenty-foot equivalent units (TEU). For air transport, the International Air Transport Association (IATA) has created a similar set of standards for aluminum container sizes designed for aircraft and associated ground handling equipment. One of the benefits of such intermodal containers is that they can be loaded at one location and delivered to a destination by various modes (e.g., ship, rail, truck) without having to open the containers.

Providing the test chamber in the transportable container provides several advantages. The test chamber is easy to build, modify, transport, replace, and remove. The investments needed are low. One particular advantage related to the ability to provide the test chamber outside the fixed buildings is an outcome in case of a fire or explosion. The electric vehicle components under test may occasionally ignite fire or even explode during the testing. Such a hazard may destroy the container, but the damages are typically limited to the container, and the damages can be overcome simply by replacing the container with a new one. The damages in terms of costs and recovery time are significantly shorter compared with a test chamber provided as fixed inside a manufacturing plant, for example. In case of the test chamber inside buildings, the extent of the damages may span to building structures that may cause extensive repairs. Such repairs may be complex, expensive, and time-consuming, and the testing may have to be suspended for a long period of time.

Fire or explosion occurring in abusive tests of electric vehicle components, may also result in gases that can be harmful for people and for the environment and thus those gases should be treated. It is also important to keep the test chamber free from harmful gases after testing the electric vehicle components by ensuring proper ventilation.

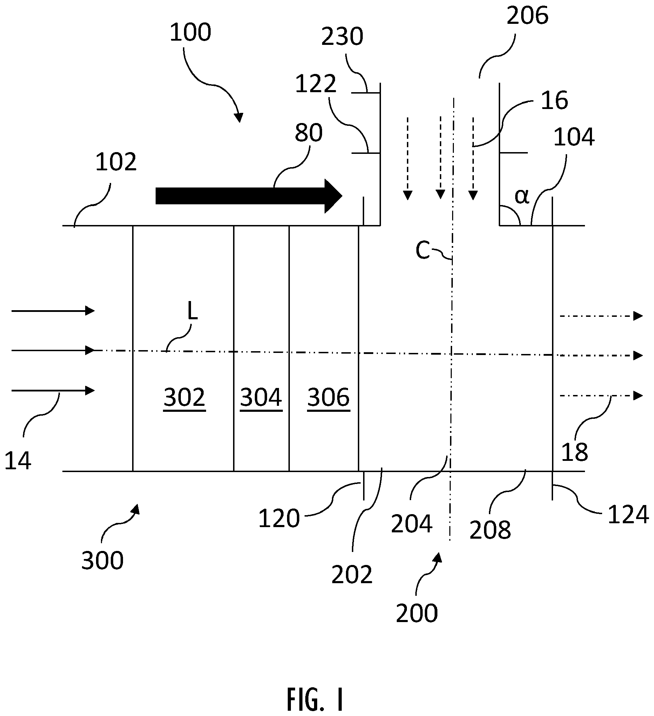

Figure 1 illustrates a gas treatment 100 arrangement for a transportable test chamber of an electric component according to an embodiment of the invention. According to an embodiment, the gas treatment arrangement 100 for a transportable test chamber 800 of an electric component 510 comprising: a channel portion 102 configured to be connectable with the test chamber 800 and comprises a gas cleaning apparatus 300; the gas cleaning apparatus comprises an oxidation catalyst 304 and a particulate filter 306; and the gas cleaning apparatus 300 further comprising a temperature control arrangement 302 arranged upstream of the oxidation catalyst 304 and the particulate filter 306, wherein the temperature control arrangement is configured to control a first gas stream temperature from the test chamber 800.

Advantageously, oxidation catalyst is configured to convert undesirable gases such as carbon monoxide and hydrocarbons from the gas into carbon dioxide and water. Preferably, the oxidation catalyst will reduce hydrocarbon (CₓHₓ) component emissions. Particulate filter is configured to remove particulate matter from the first gas. Preferably, particulate filter shall remove 96-99% of particles greater than 23 nm. In other words, the particulate filter may be configured to reduce particulate matter and therefore to filter visible smoke from gases. Thus, the gas cleaning apparatus may clean the first gas stream from particulate matter and from undesired compounds. In other words, undesired compounds may be converted advantageously to desired compounds which are less harmful and/or less toxic. Undesirable gases may be converted into carbon dioxide and water.

Catalytic converters are used to convert undesirable gases such as carbon monoxide and hydrocarbons into carbon dioxide and water. The substrates used in catalytic converters preferably include a catalyst. The particulate filter may also be implemented together to the oxidation catalyst in a gas treatment apparatus to remove particulate matter (e.g., carbon based particulate matter such as soot) from the exhaust.

According to an embodiment, the temperature control system 302 comprises a heater configured to increase temperature of a first gas stream coming from the test chamber 800. In other words, the heater ensures that gas temperature is desired so that oxidation and/or chemical reactions will happen at high enough temperature. Advantageously, the heater 302 increases the gas temperature to be at least 200 °C. In other words, the temperature of the first gas stream is controlled so as to meet the temperature range in which the oxidation catalyst works such that undesirable compounds such as carbon monoxide and hydrocarbons from the first gas will be converted into carbon dioxide and water. When in use, the first gas stream will be heated by the heater 302 so that the temperature of the first gas stream meets the requirements of the oxidation catalyst 304 when introduced therein from the heater.

According to an embodiment, as specifically illustrated in figure 1, the temperature control system 302, the oxidation catalyst 304 and the particulate filter 306 are arranged in preceding order in the gas flow direction 80. In other words, the temperature control system 302 is arranged upstream of the oxidation catalyst 304, and the oxidation catalyst 304 is arranged upstream of the particulate filter 306. Gas flow direction is depicted in figure 1 with a reference number 80. The gas flow direction refers to the direction where the gases are mainly flowing in the channel portion, even though, the gases may be mixed with each other and, even though, there may be turbulences and/or swirls with the gases which may locally change the gas flows.

According to an embodiment, the gas treatment arrangement 100 comprises a mixing unit 200 arranged downstream of the gas cleaning apparatus 300, and wherein the mixing unit 200 comprises a first inlet end 202 for the first gas stream 14 to enter from the gas cleaning apparatus 300 into an internal space 204 of the mixing unit 200 and a second inlet end 206 configured to introduce a second gas stream16 to be mixed with the first gas stream coming from the gas cleaning apparatus 300.

According to an embodiment of the invention, the first gas stream 14 (shown in figure 1 with solid arrows) and the second gas stream 16 (shown in figure 1 with dashed arrows) forms a mixture of gas streams 18 (shown in figure 1 with dash-dotted arrows) when mixed together. The gases in the first gas stream and the second gas stream may react and produce a reaction product. Then, in other words, the mixture of gases may comprise a reaction product which may be exhausted from the mixing unit. Alternatively, the first and the second gas streams will be mixed while no chemical reaction takes place.

According to an embodiment, the first gas stream comprises a first gas and the second gas stream comprises a second gas. In this description, the term "first gas" refers to gases that may or may not be treated before their introduction into the mixing unit 200. So, after the filter, the second gas and the first gas are mixed in the mixing unit 200 and exhausted from the mixing unit 200. In this description, terms first gas and first gas stream may be used interchangeably. Similarly, in this description, terms second gas and second gas stream may be used interchangeably.

According to an embodiment, temperature of the second gas stream 16 is cooler than temperature of the first gas stream 14. In this case, the second gas stream 16 is configured to cool the first gas stream 14. Advantageously, the second gas stream 16 cools the gas temperature to below 120 °C, preferably to below 80 °C. In other words, temperature of the gas mixture is below 120 °C, preferably below 80 °C. Temperature of the second gas stream 16, such as fresh air from outside of the container (i.e., from outdoors), may be within a range of from -30 °C to 50 °C or from -20 °C to 40 °C depending on the ambient circumstances. Preferably the temperature of the second gas stream 16 may be at an ambient temperature.

According to an embodiment, the second gas stream 16 may be heated or cooled with a temperature control device before it is introduced via the second inlet end. The temperature control device may be, for example, a heater. The temperature control device may be, for example, a cooler.

According to an embodiment, the second gas stream is air stream, preferably fresh air stream. The term fresh air means here an air taken outside of the test chamber from the environment, in other terms outdoor air.

According to an embodiment of the invention a composition of the first gas stream 14 is substantially same as a composition of the second gas stream. In other words, the gases in the stream may be substantially the same. According to an embodiment, a composition of the first gas stream 14 differs from a composition of the second gas stream 16.

According to an embodiment, a heater 302, oxidation catalyst 304 and particulate filter 306 are arranged upstream of the gas mixing unit 200. After the heater 302, the first gas propagates to the oxidation catalyst. After the oxidation catalyst 304, the first gas propagates to the filter 306 and then into the mixing unit 200.

According to an embodiment, the heater comprises an electric heater configured to increase temperature of the first gas. The electric heater may comprise at least one electric heating element.

According to an embodiment, the gas cleaning apparatus 300 comprises means to measure and/or determine the first gas stream temperature upstream of the heater, and a control unit to control operation of the heater in response to the measured first gas temperature. In other words, the control unit may activate and/or deactivate the heater. Furthermore, the control unit may control heating temperature. For example, if the first gas stream temperature is high enough, the control unit maintains the heater in an inactive state meaning that the heater will not heat the first gas stream. The heater may then be in an idle state. In case, for example, the first gas stream temperature is lower than a desired temperature, the control unit activates the heater so that heater will heat the first gas stream to be at least at the desired temperature.

According to an embodiment, the gas cleaning apparatus 300 is arranged upstream of the gas mixing unit 200 and comprising a heater 302, oxidation catalyst 304 and a particulate filter 306 arranged in preceding order upstream of the mixing unit 200 in the gas flow direction 80. This means that in operation (or in use), the gases first flow to a heater to be heated and second to the catalyst and finally to the particulate filter before the gases are introduced into the mixing unit 200.

According to an embodiment, the mixing unit 200 further comprises a separate mixing structure 210 coupled within the internal space 204 configured to mix the first 14 and the second 16 gas streams. In other words, the mixing structure inside the channel portion in the mixing unit is configured to modify and/or break and/or deviate the gas flow. In other words, the mixing structure may also be configured to generate turbulence to gases so as to improve the mixing effect. In other words, when the first gas stream flows to and/or collides with the mixing structure, it may result in turbulent flow downstream of the mixing structure. Then or substantially simultaneously the second gas stream may be introduced and to be mixed with the first gas stream.

According to an embodiment, the mixing structure comprises at least one guide wall configured to guide and/or swirl and/or rotate and/or deviate gas flow inside the internal space 204.

According to an embodiment, the mixing structure comprises a mixing tube arranged inside the internal space 204. Advantageously, at least portion of the first gas stream flow inside the mixing tube arranged inside the internal space 204. A portion of the first gas stream may flow outside the mixing tube. The mixing tube may be called as an internal mixing tube since it is located internal space of the mixing unit. The mixing tube may extend from an inlet end of the mixing unit towards an outlet end of the mixing unit.

According to an embodiment, the guide wall is arranged around and on the mixing tube.

According to an embodiment, an exhaust flow guide extends downstream of the mixing tube for exhausting at least partially mixed gas streams. The exhaust flow guide may have a cone-like structure with open ends so forming a converging tube.

According to an embodiment, a blockage plate is arranged downstream of the exhaust flow guide and extending in perpendicular direction of the longitudinal axis L wherein the blockage plate is configured to collide the first gas stream 14 and the second gas stream 16 so as to decrease velocity of gases along the longitudinal axis L so as to improve a mixing effect.

According to an embodiment, the second inlet end 206 comprises a control valve 230 configured to control the second gas stream into the internal space 204 of the mixing unit 200. By this way, it may be possible to control the mixing effect as well.

According to an embodiment, the second gas inlet end 206 comprises a valve 230 to control the second gas stream, preferably air flow, into the internal space 204. The valve 230 configured to control air flow via the second gas inlet end 206 is shown in figure 1. In other words, the valve 230 may stop or control how much the second gas stream16 is fed into the internal space 204 of the mixing unit 200. In case the first gas stream is air stream, meaning that the test does not generate gases, the valve 230 may be closed so that no gases are fed via the second inlet end 206.

According to an embodiment of the invention, a composition of the first gas stream 14 differs from a composition of the second gas stream 16. Thus, the second gas stream 16 may dilute the first gas 14. In other terms mixing the second gas stream 16 with the first gas stream 14 forms a diluted mixture of gases 18 compared to the gas of the first gas stream 14. In other words, mixing, for example, when fresh air as the second gas stream is mixed with the first gas stream, concentration of explosive compounds will be diluted so that the risk and/or probability of explosion is mitigated and/or reduced. Preferably, the second gas stream 16 dilutes and cools the first gas stream 14 so as to form cooled and diluted mixture of gases.

According to an embodiment, the first gas stream 14, resulted in testing of the electric component, comprises at least one of the following compounds alone or in combination: carbon dioxide, nitrogen oxides, sulfur oxides, carbon monoxides, electrolyte vapor and/or hydrocarbons before introduction into the gas cleaning apparatus 300.

According to an embodiment, the second inlet end 206 may be a channel part integrated with the channel portion, as illustrated in figure 1. The second inlet end 206 may comprise a flange 122.

According to an embodiment, the second inlet end, in other words the channel part, may be substantially perpendicularly oriented to the longitudinal axis L. In other words, the angle α (depicted in figure 1) between the second inlet end 206 and the channel portion is substantially 90 degrees. The angle α (depicted in figure 1) between the second inlet end 206 and a wall of the channel portion is substantially 90 degrees. In other words, the flow direction of the second gas 16 within the second inlet end 206 is substantially perpendicular to the longitudinal axis L of the channel portion. The angle α may be different to 90 degrees. In other words, the flow direction of the second gas 16 within the second inlet end 206 is substantially different to 90 degrees. However, the angle α may be less than 90 degrees, for example 45 degrees configured to guide the second gas stream in an angle towards the first gas stream. In other terms the second gas stream may be substantially counter flow against the first gas stream. The angle α may be more than 90 degrees, for example 135 degrees configured to guide the second gas stream in an angle to the first gas stream. In other words, the second gas stream may be substantially angled with the first gas stream. Advantageously, the flow direction of the second gas stream is substantially the same as the angle α in respect to the longitudinal axis L.

As illustrated in figure 1, the mixing unit 200 may be a module comprising flanges 120, 122 so that the mixing unit can be easily assembled and retrofitted to different configurations. The first flange 120 is located at the first inlet end of the mixing unit 200 and the second flange 122 is located at the second inlet end of the mixing unit 200. Third flange 124 (shown in figure 1) is located at the outlet end of the mixing unit 200. Therefore, in case there is a need to maintain or change the mixing unit 200, it may be easily done due to the modularity and flange connection.

Referring to figure 1, the gas treatment arrangement comprises: a channel portion 102 connectable in flow connection with the test chamber and comprising a mixing unit 200 being connectable with the gas cleaning apparatus 300 comprising at least the oxidation catalyst 304 and the particulate filter 306; the mixing unit 200 having at least the first inlet end 202 for the first gas stream to enter from the gas cleaning apparatus 300 into the internal space 204 of the mixing unit 200 and the second inlet end 206 on a wall 104 of the channel portion 102 configured to introduce the second gas stream 16 into the internal space 204 of the mixing unit 200; the mixing structure 210 arranged within the internal space 204 configured to mix the first gas stream14 with the second gas stream 16; and the mixing unit 200 further comprises the outlet end 208 for exhausting mixed gas streams 18.

In other words, the channel portion 102 is configured to be connectable in flow connection with the test chamber and comprising a mixing unit 200. The mixing unit 200 is configured to be connectable with a gas cleaning apparatus 300. Advantageously, the first gas stream and second gas stream are mixed efficiently within the mixing unit. The mixing unit may be formed between the first inlet end and outlet end and may provide enough residence time for the first and the second gases to react and/or to be mixed.

The term "end" should be understood broadly to referring to an end area, in other terms an end portion. This means that the term "end" does not mean only the very the end of the part. For example, the term "end" can refer to portion of 1/3 portion of channel portion and thus the end extends from the very end.

The term "flow connection" herein refers to that parts are in such a way arranged that gas may flow between said parts (for example, from a first part to a second part). It should be also noted that "flow connection" allows also that there can be other parts and/or devices (such as valves) between the first part and the second part which may affect the gas flow. In other words, the term "flow connection" makes possible the gas to flow. So, the channel portion may be in flow connection with the test chamber.

According to an embodiment, the first inlet end 202 of the mixing unit 200 is substantially opposite the outlet end 208 of the mixing unit. In other words, the first inlet end and the outlet end may form a straight pipe as illustrated in figure 1.

The internal space 204 of the mixing unit 200 may be enclosed and/or surrounded by the wall of the channel portion as shown in figures 1. In other words, the channel portion forms at least partially the internal space 204. The channel portion may have preferably a circular cross-section. The cross-section refers to a cross-section that is perpendicular to a plane defined by the longitudinal axis.

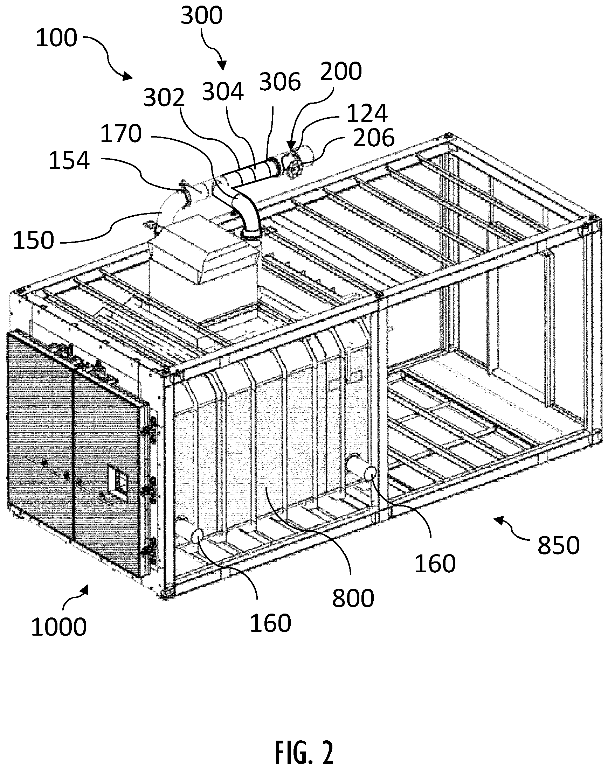

Referring now to figure 2 illustrating the gas treatment arrangement 100 according to an embodiment wherein the channel portion 102 comprises two branches 150, 170 wherein a first branch 150 and a second branch 170 extend upstream of the gas cleaning apparatus 300 to the test chamber 800. In other words, there are two separate branches 150 and 170 which will meet at the channel portion upstream of the gas cleaning apparatus. Advantageously, an inlet of the first branch is located within the test chamber and an inlet of the second branch is located within the test chamber. Preferably, a location of the inlet of the first branch differs from a location of the inlet of the second branch within the test chamber. In other words, the second branch 170, apart from the first branch, is connected with an interior 802 of the test chamber 800.

According to an embodiment, the channel portion 102 comprises two branches 150 and 170 extending from the first inlet end 202 of the mixing unit 200 in which the first branch 150 being connectable in flow connection with the testing area 500 such as the fixture within the test chamber 800 for testing electric component for guiding gases from the testing area 500 into the mixing unit 200 whereas a second branch 170 being connectable with an interior 802 of the test chamber 800 for guiding gases from the test chamber 800 into the mixing unit 200. In other words, the ventilation of air goes through the mixing unit as well as the gases generated from testing the electric component such as a battery of an electric vehicle.

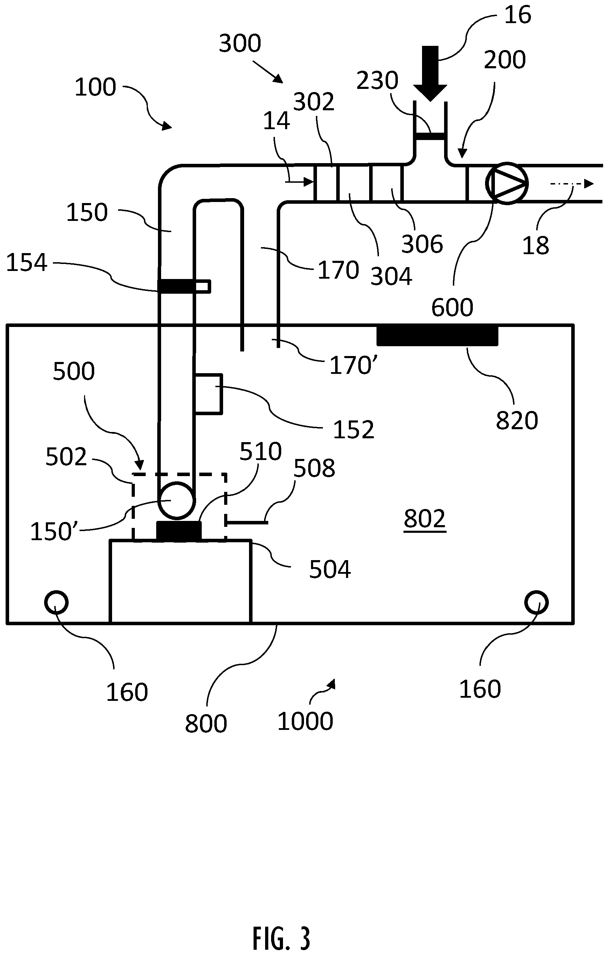

Referring now to figures 3-5, the gas treatment arrangement comprises two branches 150, 170: the first branch 150 and the second branch 170 extending upstream of the gas cleaning apparatus 300 to the test chamber 800.

According to an embodiment, the first branch 150 comprises a back-pressure valve 152 configured to relieve pressure from the first branch into the interior 802 of the test chamber 800 and wherein the first branch 150 further comprises a control valve 154 downstream of the back-pressure valve 152 configured to control gas flow towards the gas cleaning apparatus 300.

According to an embodiment, the control valve 154 is a shut-off valve.

According to an embodiment, the gas treatment arrangement 100 comprises a fan 600 downstream of the gas cleaning apparatus 300.

According to an embodiment, the gas treatment arrangement 100 comprises a fan 600 downstream of the mixing unit 200.

Figures 2-5 illustrate also a transportable test arrangement 1000 for an electric component 510 according to embodiments of the invention. The transportable test arrangement 1000 for an electric component 510 comprising a transportable test chamber 800, wherein the test arrangement 1000 comprises a gas treatment arrangement 100. So, according to an embodiment, the invention relates also to a transportable test arrangement 1000 for an electric component 510 comprising a transportable container 850 having a test chamber 800 within the container 850, wherein the test arrangement further comprises the gas treatment arrangement as described herein. The concept of the invention provides a very effective system for testing the sensitive electric components that may even explode during the test.

According to an embodiment, the test chamber is configured to withstand the explosion of the component such that the damage is limited inside the chamber, in other words, the damage is limited inside the test chamber. The test chamber may be made of stainless steel and is dimensioned to withstand the possible explosion of the components to be tested.

According to an embodiment, the gas treatment arrangement 100 comprises two branches 150 and 170 extending upstream of the mixing unit 200 to the test chamber 800. In other words, the branches 150 and 170 are channels that extends upstream of the mixing unit 200. So, Figure 3 depicts the mixing unit 200 and the gas cleaning apparatus 300 and two branches 150 and 170 connected upstream the mixing unit and extending to the test chamber 800. At the bottom part of the test chamber is arranged air inlets 160 configured to introduce air into the test chamber 800. In other words, the branches 150 and 170 are channels that extend upstream of the gas cleaning apparatus 300. The branches are connected upstream of the gas cleaning apparatus 300.

In figure 2, the second inlet end 206 of the mixing unit 200 is shown to be oriented in the horizontal direction meaning that the second gas is introduced into the interior space of the mixing unit substantially horizontally. It should be noted that the orientation of the second inlet end may vary in practical circumstances. For example, in figures 1 and 3-5, the second gas is introduced into the interior space 204 of the mixing unit 200 substantially vertically.

According to an embodiment, the transportable test arrangement wherein the first branch 150 is connected in flow connection with a testing area 500 within the test chamber 800 for testing electric component 510 for controlling gas flow from the testing area 500 into the mixing unit 200 whereas the second branch 170, apart from the first branch, is connected with an interior 802 of the test chamber 800 for controlling gases from the test chamber 800 into the mixing unit 200.

According to an embodiment, the transportable test arrangement wherein the first branch 150 is connected in flow connection with the testing area 500 within the test chamber 800 for testing electric component 510 for controlling gas flow from the testing area 500 into the gas cleaning apparatus 300 whereas the second branch 170, apart from the first branch, is connected with an interior 802 of the test chamber 800 for controlling gases from the test chamber 800 into the gas cleaning apparatus 300.

Referring now to figures 3-5 which show the interior 802 of the test chamber 800 and connections therein. It should be noted that only parts and connections will be described herein which are relevant for understanding the invention. There can be other equipment in the test chamber as well which are not described here.

According to an embodiment, the test chamber comprises a testing area 500 configured to receive the electric component 510 to be tested. Referring to figure 3, the testing area 500 comprises an enclosure 502 into which the electric component 510 to be tested will be inserted. In other words, in the test chamber there can be the enclosure 502 for testing the electric component 510. The testing enclosure may be a closed cabinet or an oven. The testing area 500 and/or enclosure 502 is configured to receive an electric component 510 for testing.

In an embodiment, the cabinet 502 is gas tight.

According to an embodiment, the inlet end 150' of the first branch 150 is located at the vicinity of the testing area 500 within the test chamber 800. The cross-section of the inlet end 150' of the first branch may be circular.

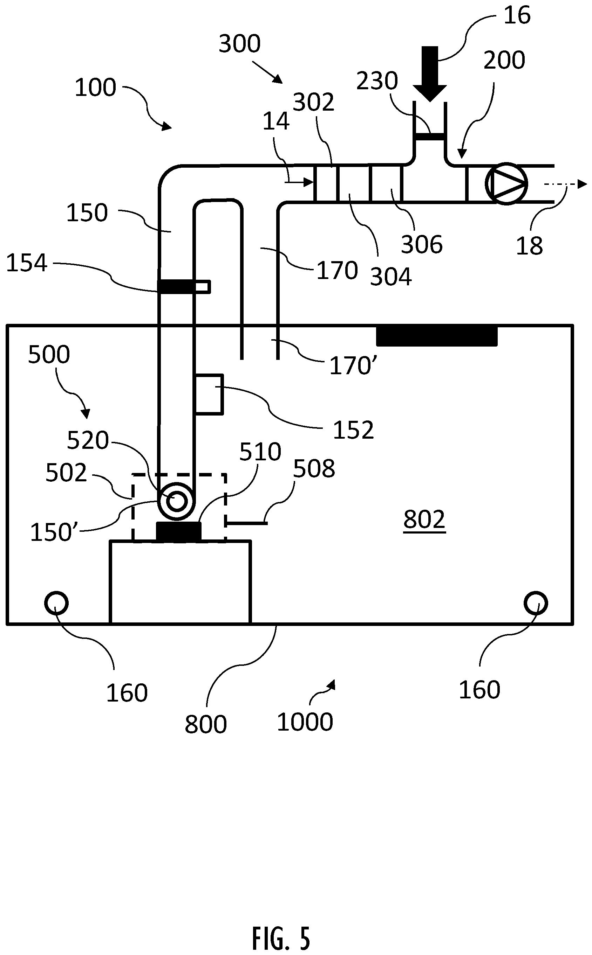

According to an embodiment, the first branch 150 comprises an inlet end 150' configured to be adjustably assembled with the testing area 500 for guiding gases from therein (as illustrated in figure 5).

According to an embodiment, the inlet end 150' of the first branch 150 is adjustable inside the test chamber 800. In other words, the location of the inlet end 150' of the first branch 150 can be moved to a desired position. For instance, the inlet end 150' of the first branch 150 may be positioned near a vent 520 in the testing area 500. The vent is located and/or integrated with the cabinet. Therefore, the inlet end 150' of the first branch 150 may not be fixedly connected to the testing area 500 such as an enclosure or a cabinet.

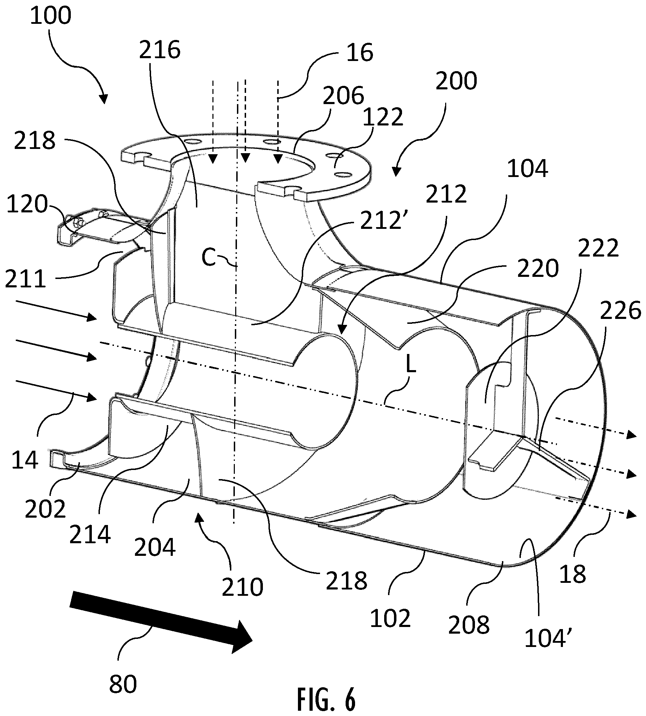

Figure 6 illustrates specifically an embodiment, wherein the testing area 500, more specifically the cabinet 502 comprises a vent 520 for releasing gases from the testing area 500. The inlet end 150' of the first branch 150 may be arranged from a distance from the vent 520. In other words, the inlet end 150' of the first branch 150 may be arranged to a predetermined distance from the vent 520.

According to an embodiment, the inlet end 150' of the first branch 150 comprises locking means to releasably lock the inlet end 150 of the first branch 150 with the testing area 500 or more specifically with the cabinet 502 of the testing area 500.

According to an embodiment, the inlet end 150' of the first branch 150 comprises locking means to releasably lock the inlet end 150 of the first branch 150 with the vent 520 of the testing area or more specifically with the vent 520 of the cabinet 502 of the testing area 500.

The testing area 500 refers to a place of the testing arrangement to which the electric component(s) is placed in the testing. In an embodiment, the testing area may comprise a fixture (test bench) or a testing jig for the electric component configured to receive the electric component. The fixture or testing jig may be lockable mechanism used to lock and unlock the electric component. Locking of the electric component prevents movement of the electric component during the testing and respectively unlocking releases the electric component allowing, for example, changing of the electric component when the testing is completed. The testing area may comprise also other components than the fixture.

The testing area 500 such as fixture, enclosure or a closed cabinet may comprise an air inlet 508 configured to introducing air from the interior 802 of the test chamber 800 into the testing area.

According to an embodiment, the testing area 500 comprises a cabinet 502 configured to receive the electric component 510 and wherein the cabinet 502 comprises a valve 508 for controlling air introduction from the interior 802 of the test chamber 800 into the cabinet 502. Furthermore, according to an embodiment, the valve 508 connected with the cabinet 502 is configured to be closed during testing the electric component and to be open when testing of the electric component is over. The valve 508 may be a flap valve. The valve is configured to control air from the chamber into the cabinet. The valve 508 may preferably be configured to participate in ventilation of the cabinet after testing for controlling gas flow from the cabinet towards the gas cleaning apparatus. In other terms, the harmful compounds may be flown to the gas cleaning apparatus 300 so that the cabinet 502 may be cleaned with the harmful compounds.

Figure 3 illustrates also air inlets 160 for letting air to flow into the interior 802 of the test chamber 800. In other words, the ventilation of air is directed via the air inlets 160 into the interior 802 of the test chamber 800 and from the interior 802 of the test chamber 800 via the second branch 170 to and through the mixing unit 200. The air inlets 160 may be provided with a back-pressure valve to prevent flow from the test chamber to the exterior of the container 850 through a wall of the test chamber 800. In figure 3, the air inlets 160 are arranged at a wall of the test chamber. However, it may be possible that at least one or more air inlet 160 is located at the roof or ceiling of the test chamber 800. From the interior 802 of the chamber 800, the air may be flown via the second branch 170. From the interior 802 of the chamber 800, the air may also be flown into the cabinet 502 via the valve 508.

According to an embodiment, the test chamber 800 comprises at least one air inlet 160 configured to introduce air into the test chamber 800 and wherein the at least one air inlet 160 comprises a back-pressure valve configured to prevent gas from the test chamber to outside. In other words, potentially harmful gases may not be exhausted outside via the air inlets and/or without cleaning them in the gas treatment arrangement. The air inlets 160 may be arranged at a wall of the test chamber.

In an embodiment, the interior of the test chamber is gas tight. In another embodiment, the interior of the test chamber is a fireproof and/or a splinter-proof. When the test chamber is the fire- and splinter-proof, it can withstand the explosion of the component(s) to be tested. When the test chamber is gas tight, it keeps the gases that may be released from the explosion of the component inside the test chamber. For example, the explosion of the battery may release toxic gases.

As illustrated in figures 3-5, according to an embodiment, the inlet end 170' of the second branch 170 is located at the roof of the test chamber. The inlet end of the second branch 170 refers to an end to which gases are flown from the interior 802 of the test chamber 800. The inlet end 170' of the second branch 170 may then suck the gases from the test chamber 800 so as to participate in the ventilating gases from the test chamber. In other words, the inlet end 170' of the second branch 170 may then suck the gases from the interior 802 of the test chamber 800 so as to participate in the ventilating gases from the test chamber. As illustrated in figures 3-5, the second branch 170 extends through the ceiling of the test chamber 800. This means that the inlet end 170' of the second branch 170 is located inside the test chamber whereas the second end of the second branch is located outside the test chamber 800. Even though, figures 3-5 illustrate that the first and the second branch go through the roof, it may be possible that at least one of the branches extends through the side wall of the test chamber.

According to an embodiment, as illustrated in figure 3, the inlet end of the first branch is connected to the enclosure for testing the electric component. In other words, the first branch can be directly configured to convey gases from the enclosure (or in other words, the cabinet) into the channel portion.

According to an embodiment, the first branch 150 is provided with a back-pressure valve 152 configured to relieve pressure from the testing jig or area and control flow of the exhaust gases into the interior 802 of the test chamber 800 and the first branch 150 further comprises a control valve 154 downstream of the back-pressure valve configured to control gas flow from the testing area into the channel portion.

According to an embodiment, the first branch 150 is provided with a first valve 152 configured to relieve pressure from the testing area 500 and control flow of the exhaust gases into the interior 802 of the test chamber 800 and the first branch 150 further comprises a second valve 154 downstream of the first valve 152 configured to control test circumstances in testing area 500 by limiting gas flow from the testing area into the channel portion 102 via the first branch 150 and opening the second valve 154 after testing so allowing gases from testing area 500 to flow via the first branch 150 into the channel portion 102. According to an embodiment, the first valve 152 is a control valve. The first valve may then be involved in controlling circumstances in the testing area 500. According to an embodiment, the first valve 152 is a back-pressure valve. According to an embodiment, the second valve 154 is a control valve. The second valve may then be involved in controlling circumstances in the testing area 500. According to an embodiment, the second valve 154 is a shut-off valve. According to an embodiment, the first valve 152 is a control valve and the second valve 154 is a control valve. According to an embodiment, the first valve 152 is a back-pressure valve and the second valve 154 is a control valve.

According to an embodiment, the first branch 150 is provided with a back-pressure valve 152 configured to relieve pressure from the testing area 500 when a pre-determined threshold exceeds and control flow of the exhaust gases into the interior 802 of the test chamber 800 and the first branch 150 further comprises a control valve 154 downstream of the back-pressure valve 152 configured to control test circumstances in testing area 500 by limiting gas flow from the testing area into the channel portion 102 via the first branch 150 and opening the control valve 154 after testing so allowing gases from testing area 500 to flow via the first branch 150 into the channel portion 102.

According to an embodiment, control valve 154 downstream of the back-pressure valve 152 configured to control test circumstances in testing area 500 maintaining the control valve closed during testing so preventing gas flow from the testing area into the channel portion 102 via the first branch 150.

The back-pressure valve 152, connected with the first branch 150, is located inside the test chamber 800. The control valve 154 connected with the first branch 150 is located outside the test chamber 800. As illustrated in figures 3-5 the first branch extends through the ceiling of the test chamber 800. This means that the inlet end 150' of the first branch 150 is located inside the test chamber whereas the second end of the first branch is located outside the test chamber 800.

When in use, during the testing the electric component, the control valve 154 is kept closed so as to enabling stable test condition within the testing area. In case the pressure within the testing area increases so that a threshold of back-pressure valve is exceeded, the back-pressure valve opens and introduces gases, exhaust gases, from the testing area into the interior 802 of the test chamber 800. Then, the gases from the interior of the test chamber are exhausted via the second branch 170. After the test, the control valve 154 will be opened and gases from the testing area 500 are exhausted via the first branch 150. After the test, ventilation of air, in other words, gases from the interior of the test chamber, are exhausted via the second branch 170. The gases from the testing area coming via the first branch and gases from the test chamber meet in the channel before their introduction into the gas cleaning apparatus 300.

According to an embodiment, the transportable test arrangement comprises two branches 150, 170 extending downstream of the first inlet end of the mixing unit and wherein the first branch is connected in flow connection with a testing area within the test chamber for testing electric component for guiding gases from the testing area into the mixing unit whereas a second branch is connected with an interior of the test chamber for guiding gases from the test chamber into the mixing unit.

According to an embodiment, the transportable test arrangement comprises the first branch 150 provided with a back-pressure valve 152 configured to relieve pressure from the testing area and guide the exhaust gases into the interior 802 of the test chamber 800 and the first branch 150 further comprises a control valve 154 downstream of the back-pressure valve 152 configured to guide gas flow from the testing area 500 into the channel portion 102. During testing the electric component, the control valve 154 may be closed. In case the pressure in the testing increases adequately high, the pressure relief valve 152 is configured to release the gases from the testing area 500 or enclosure 502 or in other terms cabinet 502 into the interior 802 of the test chamber 800. In this case, gases are transferred through the second branch 170 towards the mixing unit 200. According to an embodiment, gases are transferred through the second branch 170 towards the gas cleaning apparatus 300. According to an embodiment, gases are transferred through the second branch 170 towards the gas cleaning apparatus 300 and from the gas cleaning apparatus 300 to the mixing unit 200. By this way, the testing area will not be cooled due to exchange and/or transfer of air through it. Advantageously, the testing circumstances are kept balanced by transferring gases via the interior 802 of the test chamber 800 and guiding into the second branch 170.

In case the pressure during the testing remains under the predetermined level, the back-pressure valve 152 remains closed. Then, the air coming into the test chamber via the air inlets 160 will be flown via the second branch 170 towards the gas cleaning apparatus or the gas cleaning apparatus and mixing unit. Therefore, the second branch may be called as a ventilation branch to which the air is flown from the test chamber. Then, the first branch 150 may be called as an exhaust branch that is guiding gases from the testing area, preferably, after the testing is completed.

If, on the other hand, the pressure in the testing area 500, specifically in the cabinet 502 increases, the back-pressure valve 152 may control gases from the cabinet 502 into the interior 802 of the test chamber 800. So, gases flow via the back-pressure valve into the interior of the test chamber. From the test chamber gases flow towards the gas cleaning apparatus. This way damages for the oxidation catalyst and particulate filter will be mitigated.

According to an embodiment, the first branch 150 comprises an inlet end 150' arranged at the testing area 500 configured to guide gases from the testing area. According to an embodiment, the second branch 170 comprises an inlet end 170' at the ceiling portion of the test chamber 800 as illustrated in figure 3.

According to an embodiment, the gas treatment arrangement 100 comprises a fan 600 to guide the gases from the test chamber 800. Referring still to figure 3, downstream of mixing unit 200 is arranged a fan 600 that guides the gas flow away from the test chamber. In other words, the fan 600 may be an induced draft fan.

According to an embodiment, the test chamber 800 comprises a burst panel 820. The burst panel or a rupture panel or an explosion vent is configured to relief pressure caused by an explosion or another unexpected event occurred in the test chamber. By this way damages caused by explosion of electric component for the test chamber will be mitigated. The rupture panel may be provided on and through the roof of the test chamber, e.g. through the ceiling of the test chamber 800. The rupture panel may be covered by a cap against the weather. The cap may be fixed to the test chamber by wires or chains so that the cap will not project and cause damage when the rupture hatch is triggered by the pressure.

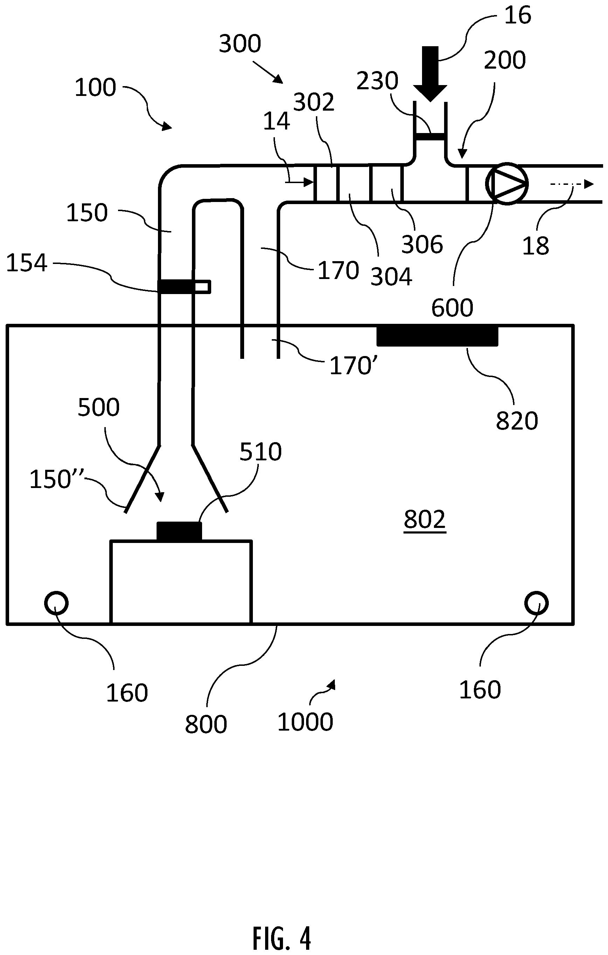

Referring now to figure 4, the gas treatment arrangement is similar to figure 3, but it does not have an enclosure or a cabinet and inlet end 150' of the first branch configured to be connected to the enclosure or the cabinet, as such. Instead, the gas treatment arrangement, in figure 4, comprises a partially open fixture or a partially open testing jig in the testing area 500. Further, the first branch 150 comprises an inlet end 150" that is formed of a cone shaped. In other words, the inlet end 150" of the first branch 150 comprises a hood, or inverted funnel or ventilation hood. In other words, a cross-section of the inlet end 150" increases the closer it gets the electric component. So, the cross-section of the inlet end 150" increases towards the ground direction. It may be possible that some (or only minor part) of the gases from testing may leak into the interior 802 of the test chamber 800. In other words, the testing area 500 may be partially open.

According to an embodiment, the invention also relates to a method of treating gases in a test chamber of an electric component. Preferably, during the testing of the electric component, gases are conveyed from the interior of the test chamber via the second branch. In other words, ventilation of the test chamber is conducted via the second branch meaning that gases from the test chamber are conveyed via the second branch to the channel portion provided with the gas cleaning apparatus, or the gas cleaning apparatus and the mixing unit. Preferably, during testing, the flow connection from the testing area via the first branch to the channel portion is kept closed. When the testing of electric component is over, the gases from the testing area may be guided, by opening the second valve 154, via the first branch into the channel portion. At the same time, it is possible to guide gases inside the test chamber via the second branch as well. This means, that gases from the test chamber are guided to the channel portion as well as the gases from the testing area are guided to the channel portion. In other terms, the first gas may comprise the gases from inside of the test chamber, for instance, air and gases from the testing, for instance, gases comprising hydrocarbons.

According to an embodiment, a method for treating gases comprises steps of: ventilating air from the test chamber through the gas cleaning apparatus arranged in the channel portion; performing a test with the electric component in a testing area of the test chamber and during testing the electric component introducing first gases generated during testing into the test chamber and from the test chamber into the gas cleaning apparatus; and after the testing the electric component introducing first gases directly from the testing area into the mixing unit.

Advantageously during testing, air flow via the test chamber will be controlled so as to prevent flammable gases from accumulating. The fan may control the flow of gases through the test chamber so that the flow (velocity) of gases is kept lower during testing and higher when the test is over.

Referring now to figure 6 illustrating an example of a mixing unit 200 comprising the mixing structure 210. According to an embodiment the mixing structure 210 comprises a mixing tube 212 that resides inside the channel portion 102 and extends from the first inlet end 202 towards the outlet end 208. The mixing tube comprises an inlet end 202 and an outlet end 208 being opposite the inlet of the mixing tube. At least portion of the first gas stream 14 is introduced via the inlet end of the mixing tube 206 into the mixing tube 206 and exhausted from the mixing tube via the outlet end. The mixing tube may have a circular cross-section which cross-section is perpendicular to the longitudinal axis. The dimensions of the mixing tube inside the channel portion may be chosen so that the diameter of the mixing tube is less than the diameter of the channel portion. In other words, the mixing tube is located fully inside the channel portion. According to an embodiment, the mixing tube 212 is supported by and/or from the internal walls 104' of the channel portion 102. According to an embodiment, support members may be extending from the inner walls of the channel portion to the mixing tube so as to support the mixing tube in place. The supporting members may generate swirls for the flow of the first gas. This may improve the mixing effect.

According to an embodiment, the inlet end 202 of the mixing tube 212 comprises a ring member 214 around the tube. The ring member extends from the outer wall 212' of the mixing tube 212. In other words, the ring member 214 is arranged on the outer wall 212' of the mixing tube 212. The ring member may be a plate. In other words, the ring may be flange-like with or without through holes, ridge, lip or rim arranged to the outer wall 212' of the mixing tube 212. The first end of the ring is attached to the outer wall of the mixing tube and the second end opposite the first end is a free end. The term free end means that the end is not fixed. There may be a gap 211 between the second end and the internal wall of the channel portion. This means that the first gas 14 may flow via the gap 211. Advantageously, the ring member 214 is configured also to guide the gas flow of the second gas 18. Namely, the ring member 214 may prevent the flow of the second gas to flow towards the inlet end of the mixing unit.

According to an embodiment, the mixing structure comprises at least one guide wall 218, or in other terms a swirl arrangement, around the mixing tube, configured to form a rotating flow around the mixing tube and to enhance the first gas flow through the mixing tube by forming some pressure around the mixing tube downstream from the peripheral first gas stream entry. In other words, the first gas stream entry refers to the inlet end of the mixing unit. This may also improve suction of the second gas to enter into the internal space of the mixing unit. In other words, when the mixing tube is provided with a guide wall or in other words a swirl arrangement, those may generate an ejector-type effect so as to enhance the flow of the second gas into the internal space of the mixing unit and so improving the mixing of second and first gases.

The mixing structure may comprise one or more guide walls extending along at least 180 degrees around the inner wall of the mixing structure. Alternatively, the mixing structure 210 may comprise one or more guide walls 218 extending along at least 180 degrees around the external wall of the internal pipe 26.2. In other words, the one or more guide walls extend between the external wall of the mixing tube and internal wall of the channel portion. The height of the guide in perpendicular direction of the longitudinal axis between the internal wall of the channel portion and external wall of the mixing tube is at least 5; 15; 25; 50; 75; 95; or 100 % of the distance of the internal wall of the channel portion and external wall of the mixing tube in perpendicular direction to the longitudinal axis. Preferably, the height of the guide wall in perpendicular direction of the longitudinal axis between the internal wall of the channel portion and external wall of the mixing tube is a distance of the internal wall of the channel portion and external wall of the mixing tube in perpendicular direction to the longitudinal axis.

The one or more guide walls may extend by at least 50; 75; 95; or 100 % in a longitudinal direction of the channel portion downstream from the first gas entry. The one or more guide walls may extend along the whole mixing tube in the longitudinal direction of the channel portion. The guide walls may have solid structure meaning that there are no holes therein. Alternatively, the guide walls may comprise holes so as to affect gas flow.

According to an embodiment, the mixing structure comprises a guide wall arranged in a helical form extending between the internal wall of the channel and an external wall of the mixing tube.

The mixing tube may have a round cross-section. The mixing tube may have a circular cross-section. The mixing tube may have an elliptic cross-section. The mixing tube may have a solid wall meaning that the wall does not comprise through-holes therein. The mixing tube may have through-holes so as to enabling gases to flow from/to the mixing tube.

According to an embodiment, the mixing structure 200 comprises at least one guide wall 218. The guide wall may be sloping wall so as to guide the gases. The guide wall may be on the mixing tube 212 and/or on an internal wall of the channel portion 102. The guide wall may be configured to form rotating flow around the mixing tube and to enhance the first gas flow through the mixing tube by forming some pressure around the mixing tube downstream from the peripheral first gas stream entry as well as enhance the second gas stream to flow around the mixing tube. The guide wall is configured to guide the gas flow and enhance mixing of gases.

According to an embodiment, the mixing structure 200 comprises a guide wall 218 in a helical form in the longitudinal direction L of the channel portion 102 and that the guide wall 218 extends between an internal wall 104' of the channel portion 102 and an external wall 212' of the mixing tube 212. The guide wall 218 may be configured to form a rotating flow around the mixing tube. The guide wall may be sloping wall so as to guide the gases. In other words and according to an embodiment, the guide wall is a swirl arrangement.

According to an embodiment, the guide wall 218 in a helical form is arranged around on the mixing tube 212. Thus, the guide wall 218 is configured to guide the second gas to flow around the mixing tube. In other words, the second gas stream may flow at least partially around the mixing tube. The guide wall also guides the gases towards the outlet end of the mixing unit.

According to an embodiment, the guide wall extends from the internal wall of the channel portion to the external wall of the mixing tube. In other words, the guide wall may support the mixing tube within the internal space of the mixing unit.

According to an embodiment, the mixing unit 200 comprises a division wall 216 at the second inlet end 206 configured to divide the second gas 16 into two gas flows. In other words, the second gas 16 is divided by the division wall 216 arranged at the second gas inlet end into two gas flows: a first inflow of the second gas and a second inflow of the second gas. The division wall 216 is configured to input the first inflow of the second gas onto a first side of the mixing tube 212 and into a second inflow of the second gas onto a second side of the mixing tube 212. The division wall 216 may extend from the second inlet end 206 towards the mixing tube 212. Preferably the division wall 216 extends substantially perpendicularly towards the mixing tube 212. The division wall 216 may be a plate.

According to an embodiment, the mixing structure 210 comprises an exhaust flow guide 220 extending downstream of the mixing tube 212 and which exhaust flow guide 220 is a cone-like internal pipe converging within the channel portion 102 in the longitudinal direction L of the channel portion 102.

According to an embodiment, wherein the mixing structure 210 comprises an exhaust flow guide 220 extending downstream of the mixing tube 212 for guiding the mixed gas stream 18, and which exhaust flow guide 220 is a cone pipe converging within the channel portion 102 in the longitudinal direction L of channel portion 102. The exhaust flow guide 220 may be called as a converging pipe. The exhaust flow guide is arranged within the channel portion 102. The exhaust flow guide may be located downstream of the second gas inlet 206. In other words, when in operation, the second gas 16 flows first towards the outer wall 212' of the mixing tube 212 and after that the second gas flows towards the exhaust flow guide 220.

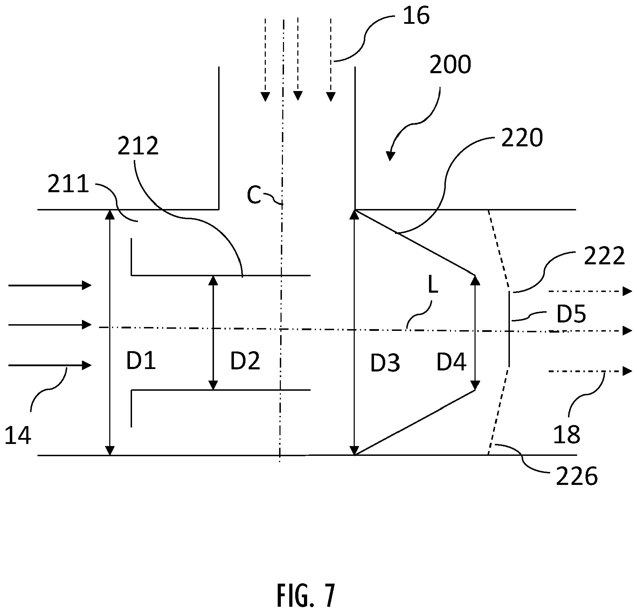

According to an embodiment, the exhaust flow guide may have a third cross-section D3 at its inlet end and a fourth cross-section D4 at its outlet end which is opposite its inlet end, as depicted in figure 7. The third cross-section D3 may be larger than the fourth cross-section D4. The converging direction is along the gas flow direction i.e. converges from the upstream to downstream in respect of the gas flow direction. In other words, the exhaust flow guide converges towards the longitudinal axis. A first end, in other words, the inlet end of the exhaust flow guide may be attached to the internal wall of the channel portion and a second end, in other words, the outlet end of the exhaust flow pipe may be free end. This means that only one end of the exhaust flow pipe is fixed to the wall of the channel portion. Here the first end of the exhaust flow guide refers to an inlet of the exhaust flow pipe and the second end of the exhaust flow guide refers to an outlet of the exhaust flow guide.

Generally speaking, inlet end of the exhaust flow guide may be called a first opening of the exhaust flow guide, and the outlet of the exhaust flow guide may be called as a second opening of the exhaust flow guide. In other words, at least partially mixed gases from via the first opening of the exhaust flow guide towards the second opening of the exhaust flow guide. The cross-section of the first opening of the exhaust flow guide may be larger than the cross-section of the second opening of the exhaust flow guide.

According to an embodiment, the outlet end 208 further comprises downstream of the exhaust flow guide 220 a blockage plate 222 arranged in the channel portion 102 and extending in perpendicular direction of the longitudinal axis L and configured to decrease velocity of gases along the longitudinal axis L so as to improve a mixing effect. In other words, the mixing unit 200 further comprises downstream of the exhaust flow guide 220 a blockage plate 222 arranged in the channel portion 102 and extending in perpendicular direction of the longitudinal axis L and configured to decrease velocity of gases along the longitudinal axis L so as to improve a mixing effect.

According to an embodiment, the outlet end 208 further comprises downstream of the exhaust flow guide 220 a blockage plate 222 arranged in the channel portion 102 and extending in perpendicular C direction of the longitudinal axis L configured to collide the first 14 and the second 16 gases so as to decrease velocity of gases along the longitudinal axis L so as to improve a mixing effect. The blockage plate is arranged downstream of the exhaust gas flow guide. The blockage plate advantageously improves mixing effect with the first and the second gas streams. At least part of the first and the second gas streams will collide with the blockage plate. In other words, the blockage plate may be configured to affect the gas flow or temporarily and/or locally deflect the flow of gases. The blockage plate may result in turbulent flow downstream of the blockage plate.

According to an embodiment, the blockage plate 222 is uniform solid plate or a perforated plate. The term "uniform solid" means that the plate is made of one material and is substantially one uniform piece.

According to an embodiment, the blockage plate is made of one or more pieces. According to an embodiment, the blockage plate is made of one piece. According to an embodiment, the blockage plate is made of one or more materials. According to an embodiment, the blockage plate is made of one material. According to an embodiment, the blockage plate is made of one material and one piece. According to an embodiment, the blockage plate comprises guide walls on its surface configured to guide gas flow.

According to an embodiment, the blockage plate 222 is a uniform solid circular plate or a perforated circular plate arranged substantially in a middle portion of the channel portion in cross-sectional C direction that is perpendicular to the direction of the longitudinal axis L. According to an embodiment, the blockage plate 222 is a uniform solid circular plate or a perforated circular plate having a center of the plate substantially at the longitudinal axis L.

According to an embodiment, the blockage plate 222 is attached to the internal wall of the channel portion (as shown in figure 1). The blockage plate 222 may be attached to support legs 226 which are fixed with the internal wall of the channel portion. In other words, the blockage plate 222 is attached to the internal wall of the channel portion with support legs 226. In figure 1, three support legs have been shown, but the number of support legs may vary in practical circumstances. The support legs 226 may be attached to downstream of the plate, in gas flow direction. The support legs may also be configured to guide the gas flows advantageously. Alternatively, according to an embodiment, the support legs may be attached to the exhaust flow guide 220. This means that the flow guide 220 may be an integral (or integrated) part of the exhaust flow guide.

According to an embodiment, a cross-sectional shape of the circular plate is same as an outlet end of the exhaust flow guide 220 and wherein a cross-sectional diameter D5 of the plate is smaller than a cross-sectional diameter D4 of the outlet end of the exhaust flow guide 220. In other words, the diameter of the blockage plate 222 is smaller than the diameter of the second opening (meaning the outlet) of the exhaust flow guide.

According to an embodiment, a cross-sectional shape of the circular plate has a cross-sectional diameter D5 smaller than a cross-sectional diameter D4 of the outlet end of the exhaust flow guide. There may be a predetermined distance between the circular plate and the outlet end of the exhaust flow guide in practical circumstances.

Referring now to the figure 7, the mixing structure 200 comprises a first cross-section in a perpendicular direction of a longitudinal axis extending between the inlet and the outlet which first cross-section is greater than a second cross-section of the channel portion located at a predetermined distance downstream at the channel portion; and the mixing structure comprises the exhaust flow guide at the outlet end forming a third cross-section in a perpendicular direction of the longitudinal axis into the channel which third cross-section is greater than a fourth cross-section of the channel portion located at a predetermined distance downstream. When the cross-sections are circular, relations apply with diameters. In other words, the first diameter D1 at the first inlet end is greater than the second diameter D2 of the mixing tube 212, the third diameter D3 at the inlet end of the exhaust guide is greater than the fourth diameter D4 at an outlet end of the exhaust guide. Furthermore, the fifth diameter D5 of the blockage plate 222 is smaller than the fourth diameter at the outlet of the exhaust guide. In other words, the first gas flows at first along the pipe that has the first cross-section (or diameter D1), then guided to smaller pipe portion having the second cross-section (or diameter D2), then guided to a pipe portion having the third cross-section (or diameter D3) which is greater than the fourth cross-section (or diameter D4). The cross-section (or diameter D5) of the blockage plate 222 is smaller than the fourth cross-section (or diameter D4).

According to an embodiment, the blockage plate may rotatably assembled. In other words, the gas flow may rotate the plate so as to generate a mixing effect and/or improve the mixing effect. According to an embodiment, the plate may rotate in perpendicular direction to the longitudinal axis.

Single features of different embodiments may also be combined to provide other embodiments. Furthermore, words "comprising" and "including" should be understood as not limiting the described embodiments to consist of only those features that have been mentioned and such embodiments may also contain features/structures that have not been specifically mentioned. All combinations of the embodiments are considered possible if their combination does not lead to structural or logical contradiction.

The term "about" means that quantities or any numeric values are not exact and typically need not be exact. The reason may be tolerance, resolution, measurement error, rounding off or the like, or a fact that the feature of the solution in this document only requires that the quantity or numeric value is approximately that large. A certain tolerance is always included in real life quantities and numeric values.

It should be noted that while Figures illustrate various embodiments, they are simplified diagrams that only show some structures and/or functional entities. The connections shown in the Figures may refer to logical or physical connections. It is apparent to a person skilled in the art that the described apparatus may also comprise other functions and structures than those described in Figures and text. It should be appreciated that details of some functions, structures, and the signalling used for measurement and/or controlling are irrelevant to the actual invention. Therefore, they need not be discussed in more detail here.

It is to be understood that at least some of the figures and descriptions are simplifications to certain extent and illustrate mainly elements that are relevant for understanding what is claimed, while eliminating, for purposes of clarity, other elements that may be included in what is claimed. However, because such elements are well known in the art, and because they do not facilitate a better understanding of the claimed features, a description of such elements is not provided herein.

The term "comprise" (and grammatical variations thereof) and the term "include" should be read as "comprise without limitation" and "include without limitation", respectively.

The term "or" is inclusive, not exclusive.

In this application, the general term "gas" may be used for both "exhaust gas" and "non-exhaust gas". In other words, gas may comprise exhaust gas and non-exhaust gas. The term "non-exhaust gas" refers to a gas such as fresh air or non-contaminated air that is not yet mixed with exhausted materials from the electric component under test. The term "non-exhaust gas" may also refer to a gas such as oxygen containing gas or non-contaminated oxygen containing compound that is not yet mixed with the exhausted materials from the electric component under test. The term exhaust gas refers to a gas generated during testing of electric component. For example, if the battery ignites, burns and/or explodes exhaust gas is produced. The exhaust gas may comprise at least one of the following: hydrogen (H2), carbon dioxide (CO2), carbon monoxide (CO), electrolyte vapors and hydrocarbon (CxHx) particles or their combinations. For example, the first gas stream may comprise exhaust gas and the second gas stream may comprise non-exhaust gas.

As discussed above, air and gases from the test chamber and/or from the testing area will be guided through the mixing unit. Therefore, the gas treatment arrangement may also be called as a ventilation and exhaust gas treatment arrangement.

It will be obvious to a person skilled in the art that, as technology advances, the inventive concept can be implemented in various ways. The invention and its embodiments are not limited to the example embodiments described above but may vary within the scope of the claims.

## Claims

1. A gas treatment arrangement (100) for a transportable test chamber (800) of an electric component (510) comprising:
a channel portion (102) configured to be connectable with the test chamber (800) and comprises a gas cleaning apparatus (300);
wherein the gas cleaning apparatus comprises an oxidation catalyst (304) and a particulate filter (306); and
the gas cleaning apparatus (300) further comprising a temperature control arrangement (302) arranged upstream of the oxidation catalyst (304) and the particulate filter (306), wherein the temperature control arrangement is configured to control temperature of a first gas stream from the test chamber (800).

2. The arrangement according to claim 1, wherein the temperature control system (302) comprises a heater configured to increase temperature of the first gas stream coming from the test chamber (800).

3. The arrangement of any preceding claim, wherein the temperature control system (302), the oxidation catalyst (304) and the particulate filter (306) are arranged in preceding order in the gas flow direction (80).

4. The arrangement of any preceding claim, comprising a mixing unit (200) arranged downstream of the gas cleaning apparatus (300), and wherein the mixing unit (200) comprises a first inlet end (202) for the first gas stream (14) to enter from the gas cleaning apparatus (300) into an internal space (204) of the mixing unit (200) and a second inlet end (206) configured to introduce a second gas stream (16) to be mixed with the first gas stream coming from the gas cleaning apparatus (300).

5. The arrangement according to claim 4, wherein the mixing unit (200) further comprises a separate mixing structure (210) coupled within the internal space (204) configured to mix the first (14) and the second (16) gas streams.

6. The arrangement according to claim 4 or 5, wherein the second inlet end (206) comprises a control valve (230) configured to control the second gas stream into the internal space (204) of the mixing unit (200).

7. The arrangement of any preceding claim, wherein the channel portion (102) comprises two branches (150, 170) wherein a first branch (150) and a second branch (170) extend upstream of the gas cleaning apparatus (300) to the test chamber (800).

8. The arrangement according to claim 7, wherein the first branch (150) comprises a back-pressure valve (152) configured to relieve pressure from the first branch into the interior (802) of the test chamber (800) and wherein the first branch (150) further comprises a control valve (154) downstream of the back-pressure valve (152) configured to control gas flow towards the gas cleaning apparatus (300).

9. The arrangement of any preceding claim, comprising a fan (600) downstream of the gas cleaning apparatus (300).

10. A transportable test arrangement (1000) for an electric component (510) comprising a transportable container (850) having a test chamber (800) within the container (850), wherein the test arrangement further comprises the gas treatment arrangement (100) of any of claims 1-9.

11. The transportable test arrangement (1000) of claim 10, wherein the first branch (150) is connected in flow connection with a testing area (500) within the test chamber (800) for testing electric component (510) for controlling gas flow from the testing area (500) into the mixing unit (200) whereas the second branch (170), apart from the first branch, is connected with an interior (802) of the test chamber (800) for controlling gases from the test chamber (800) into the mixing unit (200).

12. The transportable test arrangement of claim 11, wherein the first branch (150) is provided with a back-pressure valve (152) configured to relieve pressure from the testing area (500) when a pre-determined threshold exceeds and control flow of the exhaust gases into the interior (802) of the test chamber (800) and the first branch (150) further comprises a control valve (154) downstream of the back-pressure valve (152) configured to control test circumstances in testing area (500) by limiting gas flow from the testing area into the channel portion (102) via the first branch (150) and opening the control valve (154) after testing so allowing gases from testing area (500) to flow via the first branch (150) into the channel portion (102).

13. The transportable test arrangement of any of claims 11-12 wherein the first branch (150) comprises an inlet end (150') configured to be adjustably assembled with the testing area (500) for guiding gases from therein.

14. The transportable test arrangement of any of claims 10-13 wherein the testing area (500) comprises a cabinet (502) configured to receive the electric component (510) and wherein the cabinet (502) comprises a valve (508) for controlling air introduction from the interior (802) of the test chamber (800) into the cabinet (502).

15. The transportable test arrangement of any of claims 10-14 wherein the test chamber (800) comprises at least one air inlet (160) configured to introduce air into the test chamber (800) and wherein the at least one air inlet (160) comprises a back-pressure valve configured to prevent gas from the test chamber to outside.
